# EUROPEAN PATENT SPECIFICATION

(11) **EP 1 984 152 B1**
(45) Date of publication and mention of the grant of the patent: **10.04.2013**
(21) Application number: 07750410.8
(22) Date of filing: 09.02.2007
(51) Int. Cl.: B26B 21/60, C23C 14/34, C23C 28/00, C09D 127/18

(54) **METHOD FOR PRODUCING A MULTI-LAYER COATING FOR RAZOR BLADES**
VERFAHREN ZUR HERSTELLUNG EINER MEHRSCHICHTIGEN BESCHICHTUNG FÜR RASIERKLINGEN
PROCÉDE DE FABRICATION D'UN REVÊTEMENT MULTICOUCHE POUR LAMES DE RASOIR

(30) Priority: 10.02.2006 US 772379 P
(43) Date of publication of application: 29.10.2008
(73) Proprietor: Eveready Battery Company, Inc., St. Louis, Missouri 63141 (US)
(72) Inventor: BECKER, Sandra, 42659 Solingen (DE); CAMPHAUSEN, Scott, Milford, CT 06460 (US); NICOLOSI, Randy, Shelton, CT 06484 (US); THOENE, Jochen, 42360 Wuppertal (DE); NIGGEMANN, Matthias, 42119 Wuppertal (DE)
(74) Representative: von Kreisler Selting Werner
(86) International application number: PCT/US2007/003571
(87) International publication number: WO 2007/095120

(56) References cited:
- EP-A1- 0 363 648
- EP-A1- 1 287 953
- WO-A-87/04471
- WO-A-2007/064699
- US-A- 5 669 144
- US-A1- 2005 268 470
- US-B2- 6 821 624

## Description

### Background of the Invention

### Technical Field

This invention relates generally to shaving devices, and more specifically to a method of making razor blades having multi-layer coatings.

### Background Information

A razor blade is typically formed of a suitable substrate material, such as stainless steel. A cutting edge is provided to the razor blade, typically by grinding and honing. The cutting edge has a wedge-shaped configuration with a sharpened tip having a radius less than 100 nm, e.g., 20-50 nm. Hard carbon coatings such as amorphous diamond or diamond-like carbon (DLC) material are often used to improve hardness, strength, corrosion resistance and shaving ability. The hard carbon coating maintains the required strength of the ultimate tip while permitting more acutely angled wedge shapes with consequently lower cutting forces to be used. A polytetrafluoroethylene (PTFE) outer layer can be used to provide friction reduction. The adhesion of a hard carbon material such as amorphous diamond or DLC to a stainless steel substrate can be promoted by providing an undercoat layer of an adhesion promoting material between the substrate and the hard carbon layer. It is known in the art to provide a layer of chromium or niobium containing materials as an adhesion promoting layer. This is describe in US Patent Number 6,684,513 to Clipstone et al. In practice, a magnetron target (as will be discussed later in the instant application) to provide a niobium layer costs 50% more than a target for a chromium layer and is consequently not preferred for reasons of manufacturing cost The use of chromium is well known in the art, it promotes adequate adhesion and it provides a good solution to this problem.

WO-A-2007/064699 discloses an interlayer between the hard coating (carbon) layer and the substrate (stainless steel) of an razor blade and suitable materials therefore, such as niobium, chromium, titanium, chromium nitrate, titanium nitrate or titanium carbide.

EP-A-1287953 describes a (cutting) blade comprising an intermediate layer comprising a metal such as titanium and further mixture layers comprising mixtures of, e.g. Pt, Zr, W, Ti, Ag, Cu and a hard carbon material such as DLC (Diamond-Like-Carbon) as well as nitrides, oxides, borides and carbides of the above-mentioned metals.

EP-A-0363648 discloses a method of forming or modifying the cutting etches of razor blades, which comprises subjecting a stack of a razor blades to ion bombardment from two ion sources in a vacuum chamber, the ion sources being located on opposite sides of a place which lies within the stack and parallel to the major surfaces of the blades and the ion sources having the axes of their ion beams directed at the edges of the razor blades in the stack and the ion bombardment being effected with ions of sufficient mass and energy, in relation to the material of which the razor blades are formed, to cause sputter removal of the material of the blades on both sides of the edges thereof to thereby form or modify their cutting edges.

US Patent No. 6,821,624 describes amorphous carbon covered members having an interlayer comprising at least one element selected from the group consisting of elements in the IVa, Va, VIa and IIIb groups and the IVb group except carbon in the periodic table, or a carbide of at least one element selected from the group, and an amorphous carbon film formed on the interlayer.

Under extreme shaving conditions, the sharpened tip of the razor blade can undergo small elastic deformations. If the sharpened tip has a hard coating, these deformations can result in micro cracks in the outer surface of the hard coating. If the hard coating is intimately bonded to the substrate or to an undercoat, which is in turn intimately bonded to the substrate, the crack in the hard coating can propagate through to the substrate resulting in premature failure of the sharpened tip of the razor blade. This can result in an unpleasant shaving experience. Titanium is tougher and more elastic than chromium and can advantageously act to arrest the propagation of micro cracks into the substrate. Some comparative pertinent properties of titanium and chromium are listed in the following table:

| Property | Titanium | Chromium |
|---|---|---|
| Tensile Modulus (GPa) | 116 | 279 |
| Poisson's ratio | 0,32 | 0,21 |
| Hardness (Hv) | 970 | 1060 |

Based on the foregoing, it is the object of the present invention to provide a cutting edge of a razor blade with a layer of a titanium containing material as an adhesion promoter for a subsequent layer of a hard carbon containing material.

### Summary of the Invention

The present invention provides a method of making a razor blade as defined in claim 1. Preferred embodiments of the invention are apparent from the dependent claims.

The razor blades made according to the method of the invention can be used in a safety razor including a handle and a housing that includes at least one razor blade, *supra.* The housing can also include at least four razor blades, *supra.*

The invention features, in general, a method of making a razor blade by providing substrate with a cutting edge defined by a sharpened tip and adjacent facets. A layer of titanium containing material is applied to the cutting edge by a physical vapor deposition (PVD) process. The PVD process can be a sputtering process or a cathodic arc deposition process. A layer of hard carbon material is coated on the titanium containing material. An outer layer of PTFE is provided. A sputtering process to deposit the titanium containing material may include two stages. In a first stage; at least a first bias voltage more positive than -700 volts is applied to the razor blade and the razor blade is in a first atmosphere that includes Argon at a pressure less than 6.65 Pa (50 milliTorr). In a second stage the titanium containing material is implanted with carbon to form a partial titanium carbide layer. In this second stage the razor blade is in a second atmosphere that includes Argon at a pressure less than 3.99 Pa (30 milliTorr). In this second stage a second bias voltage more positive than -1500 volts is applied to the razor blade. Subsequent layers of hard carbon material and PTFE are applied by well known processes.

Embodiments of the invention may include one or more of the following advantages. The use of a titanium containing material on the cutting edge of a razor blade promotes adhesion of the hard carbon material. The cutting edge of the razor blade has improved resistance to failure by crack propagation. The razor blade has excellent shaving characteristics.

The above features and advantages of the present invention will be more fully understood with reference to the following detailed description when taken in conjunction with the accompanying drawings.

### Brief Description of the Drawings

FIG. 1 is a sectional view of a cutting edge portion of a razor blade of the present invention.
FIG. 2 is a front isometric view from above of a safety razor of the present invention.

### Detailed Description of a Particular Embodiment

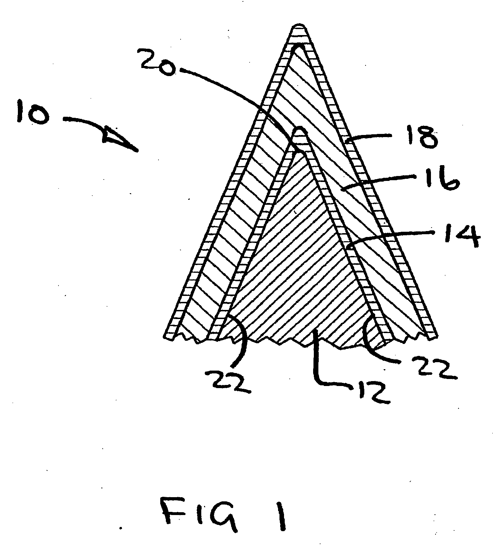

Referring to now to the drawings, and in particular Fig. 1, the cutting edge portion of a razor blade 10 comprises a substrate 12, a layer of titanium containing material 14, a layer of hard carbon material 16 and an outer layer of polytetrafluoroethylene (PTFE) 18. The substrate 12 is typically made of stainless steel, although other substrates such as an amorphous alloy, a carbon steel or a ceramic material can be employed. A preferable stainless steel is disclosed in US Patent Number 5,275,672 to Althaus et al and is most preferably the grade designated GIN 7 manufactured by HITACHI. One of skill in the art will understand that other stainless steel materials may be used. The substrate is typically supplied in an annealed state as an elongated flat strip, wound in a coil and is preferably 0,05mm to 0,1 mm thick, most preferably 0,1 mm, and is preferably 3mm wide but can be from 2mm to 23mm wide. The substrate may be perforated as is known in the art. The substrate is hardened, again as is known in the art to a hardness 900 on the Vickers scale (Hv). The substrate is sharpened to provide a cutting edge having a sharpened tip 20 of radius less than 100 nm and preferably 20-50 nm. The sharpened tip has adjacent facets 22 having an included angle less than 30 degrees and preferably 15-20 degrees measured 40 nm from the sharpened tip. The sharpening process includes grinding and honing stages and may include a further stropping stage. The sharpening process may be performed on both edges of the elongate substrate but is preferably on one edge only. As the elongate substrate exits the sharpening process it may be cut into individual razor blades and stacked one on the other, or preferably the elongate substrate is recoiled on to a carrier with the sharpened edge facing outward. The substrate is subsequently cleaned by any one of a number of processes known in the art to remove residues from the sharpening process and other contamination. Samples of the substrate are analyzed for cleanliness preferably by a photoelectron emission technique. Suitable measuring equipment is supplied by PET PHOTO EMISSION TECHNOLOGY and is designated SQM300. A substrate with an OSEE (optically stimulated electron emission) value at least 450 is adequately clean.

At least one carrier with recoiled substrate is loaded vertically (that is, with the axis of its coils horizontal) within a vacuum chamber. The vacuum chamber includes a target preferably comprising titanium, and two cathodic arc sources. The target may also comprise titanium alloyed with any carbide forming metal that comprises at least 51% titanium by atomic percent. Suitable process equipment including a vacuum chamber is manufactured by IONBOND. The vacuum chamber may alternately be constructed to have one or more stacks of razor blades loaded therein.

The process steps performed within the vacuum chamber are as follows:
In a first step, the vacuum chamber is sealed and evacuated to 0.3 mPa (20 microTorr) and a rate ofrise test performed to ensure the chamber has no vacuum leaks.

The following glow discharge step removes minor contamination that might remain on the cutting edges. Oxygen is introduced into the chamber to a pressure of 2.00 to 5.99 (15 to 45 milliTorr). A bias voltage of -500 Volts is applied to the substrate and this is increased to - 1000 Volts and held for 2 minutes. In all process steps herein where a bias voltage is cited, this is preferably a pulsed square wave, pulsed from 0 Volts to the specified bias voltage at 25 kHz and a duty cycle of 62%. Other wave forms and frequencies may be employed. One of skill in the art will understand that the hard carbon material, *infra,* is a semi-conductor and requires a pulsed DC bias rather than a pure DC bias to avoid creating a static charge on the substrate. The oxygen supply is closed and argon is introduced into the chamber while the substrate is held at -1000 Volts. The vacuum chamber is then evacuated to 6.65 mPa (50 microTorr).

The glow discharge step is followed by a magnetron sputtering step that cleans the surface of the target and subsequently deposits the titanium containing material on the cutting edges. A shutter is closed which masks the target. Argon is introduced into the chamber to a pressure of 0.266 to 2.66 Pa (2 to 20 milliTorr). The power on the target is set to a power density of 14 W/cm² to 28 W/cm². These conditions are held for 1-3 minutes as a pre-sputter step to clean the surface of the target. The shutter is then opened, exposing the target to the cutting edges so that the titanium containing material may be deposited on the cutting edges. A high bias voltage of -200 to -700 Volts, preferably -500 Volts, is applied to the substrate for about one minute. This high bias step is necessary to achieve adequate bonding of the titanium containing material to the sharpened tip of the cutting edge. The bias voltage is then reduced to a low bias setting of -20 to -60 volts for about 2 to 5 minutes. A minimum thickness of titanium containing material of 5 nm is deposited on the cutting edge.

The magnetron sputtering step is followed by a preferred a-Diamond or amorphous diamond step that deposits a hard carbon material of amorphous diamond on the titanium containing material. The hard carbon material may also be Diamond-like Carbon (DLC). Two cathodic arc sources are preferably situated such that each carbon beam is approximately normal to one of each facet of the cutting edge. This is the optimum arrangement that will provide hardest coating. Suitable coatings however are achieved with a narrower angle of 60 degrees between the two carbon beams. Argon is introduced into the chamber to a pressure of 2.66 mPa to 1.197 Pa (20 microTorr to 9 milliTorr). The cathodic arc sources are set at 50 to 65 Amps with an initial bias voltage of -500 to -1000 Volts applied to the substrate. The initial phase of this a-Diamond step implants carbon in the titanium containing material layer to form a partial titanium carbide layer. This partial carbide layer is necessary to ensure adequate adhesion of the hard carbon material to the titanium containing material layer. This step is continued to deposit a hard carbon layer 20 nm to 150 nm thick, with a preferred thickness of 20 to 80 nm.

The vacuum chamber is vented and the substrate removed. In a subsequent process, well known to one of skill in the art, an outer layer of polytetrafluoroethylene (PTFE) is deposited. A suitable PTFE is DRYFILM LW1200 manufactured by DUPONT, having a molecular weight of 40,000. The DRYFILM LW1200 is preferably diluted with alcohol as disclosed in US Patent Application serial number 60/741,144. One of skill in the art will understand other PTFE materials may be employed.

A razor blade 10 is manufactured generally to the processes described herein. Individual razor blades may be in stack form or the coiled substrate may subsequently uncoiled and cut to a convenient length to form a single razor blade.

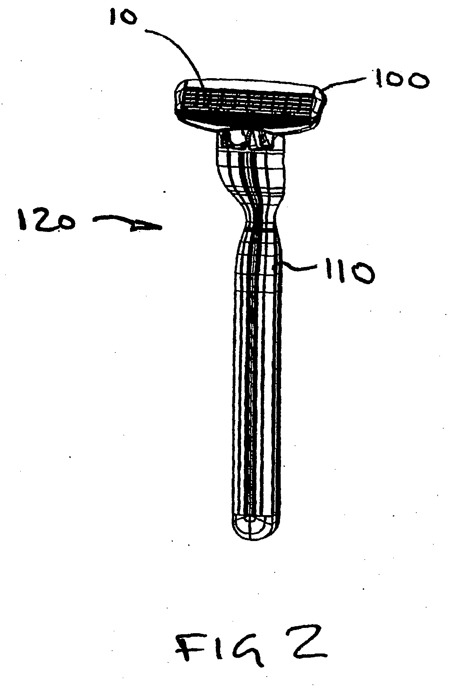

Referring now to Fig. 2, at least one razor blade is mounted in a housing 100. The housing, with its razor blade or blades is selectively connected to a handle 110 to provide a safety razor 120. The housing may contain one, two or three razor blades but preferably at least four. The housing may be permanently or removably connected to the handle.

In use, the cutting edge portion of the razor blade 10 has improved resistance to failure by crack propagation compared to known cutting edges of razor blades having chromium coatings between their substrate and hard carbon coatings. The use of a titanium containing material on the cutting edge of a razor blade promotes adhesion of the hard carbon material. The razor blade has excellent shaving characteristics.

## Claims

1. A method of making a razor blade (10), comprising:
a substrate (12) with a cutting edge defined by a sharpened tip (20) and adjacent facets (22),
a layer of titanium containing material (14) on the cutting edge,
a layer of hard carbon material (16) on the titanium containing material layer (14), and
an outer layer of polytetrafluoroethylene (18)
wherein the layer of titanium containing material (14) is a partial titanium carbide layer, said method comprising:
providing the substrate (12) with the cutting edge defined by the sharpened tip (20) and adjacent facets (22), adding the layer of titanium containing materials (14) to the cutting edge, adding the layer of hard carbon material (16) to the titanium containing material layer (14), and adding the outer layer of polytetrafluoroethylene (18), wherein the layer of titanium containing material (14) includes depositing the titanium containing material layer (14) by a physical vapor deposition process,
wherein the physical vapor deposition process is a sputtering process,
wherein the sputtering process is performed in a vacuum chamber that includes a target that comprises titanium,
wherein the process steps carried out in said vacuum chamber comprise the following steps:
i) a glow discharge step comprising introducing oxygen into the vacuum chamber to a pressure of 2.00 to 6.00 Pa (15 to 45 milliTorr),
applying a voltage of -500 V to the substrate (12), increasing the voltage to - 1000 V and holding it for 2 minutes,
closing the oxygen supply, introducing argon and then evacuating the vacuum chamber to 6.66 mPa (50 microTorr);
ii) a magnetron sputtering process comprising introducing argon into the vacuum chamber to a pressure of 0.267 to 2.67 Pa (2 to 20 milliTorr),
applying a power density of about 14 W/cm² to 28 W/cm² to the target for a time of 1 to 3 minutes,
applying at least a high bias voltage of -200 to -700 V to the substrate (12) for one minute, and
applying a low bias voltage of -20 to -60 V to the substrate (12) for 2 to 5 minutes thereby depositing a minimum thickness of titanium containing material of 5 nm on the cutting edge;
iii) an a-diamond step or diamond-like carbon (DLC) step,
introducing argon into the vacuum chamber to a pressure of 2.66 mPa to 1.20 Pa (20 microTorr to 9 milliTorr),
setting the cathodic arc sources at about 50 to 65 amps with an initial bias voltage of about -500 to -1000 V applied to the substrate (12) to form the partial titanium carbide layer (14);
iv) continuing step iii) to deposit a hard carbon layer (16) 20 to 150 nm (200 to 1500 Angstroms) thick;
wherein the sputtering process is performed in a first atmosphere comprising Argon having a pressure less than 6.65 Pa (50 milliTorr), wherein the titanium containing material layer (14) is implanted with carbon to form a partial titanium carbide layer, wherein the implanting is performed with a second bias voltage more positive than -1500 volts applied to the razor blade.

2. The method according to claim 1, wherein in step iii) two cathodic arc sources are situated such that each carbon beam is normal to one of each facet (22) of the cutting edge.

3. The method according to claim 2, wherein the two cathodic arc sources are situated with an angle of 60 degrees between the two carbon beams.

4. The method according to claim 1, wherein the hard carbon material is selected from the group consisting of diamond-like carbon and amorphous diamond.

5. The method according to claim 1, wherein the polytetrafluoroethylene has a molecular weight of 40,000.

6. The method according to claim 1, wherein the polytetrafluoroethylene layer (18) is on the layer of hard carbon material (16).

7. The method of claim 4, wherein the layer of hard carbon material (16) has a thickness between 20 and 80 nm.

## Patentansprüche

1. Verfahren zur Herstellung einer Rasierklinge (10), die Folgendes umfasst:
ein Substrat (12) mit einer Schneidkante, die durch einen geschärften Grat (20) und daran angrenzende Fasen (22) definiert ist;
eine Schicht aus titanhaltigem Material (14) auf der Schneidkante;
eine Schicht aus Hartkohlenstoffmaterial (16) auf der Schicht aus titanhaltigem Material (14); und
eine äußere Schicht aus Polytetrafluorethylen (18);
wobei die Schicht aus titanhaltigem Material (14) eine partielle Titancarbidschicht ist;
wobei das Verfahren Folgendes umfasst:
Bereitstellen des Substrats (12) mit der Schneidkante, die durch den geschärften Grat (20) und die angrenzenden Fasen (22) definiert ist, Hinzufügen der Schicht aus titanhaltigem Material (14) zu der Schneidkante, Hinzufügen der Schicht aus Hartkohlenstoffmaterial (16) zu der Schicht aus titanhaltigem Material (14) und Hinzufügen der äußeren Schicht aus Polytetrafluorethylen (18), wobei das Hinzufügen der Schicht aus titanhaltigem Material (14) das Abscheiden der Schicht aus titanhaltigem Material (14) durch ein physikalisches Aufdampfverfahren umfasst;
wobei das physikalische Aufdampfverfahren ein Sputterverfahren ist;
wobei das Sputterverfahren in einer Vakuumkammer, die ein Target umfasst, das Titan umfasst, durchgeführt wird;
wobei die in der Vakuumkammer durchgeführten Verfahrensschritte die folgenden Schritte umfassen:
i) einen Glimmentladungsschritt, der das Einleiten von Sauerstoff in die Vakuumkammer bis zu einem Druck von 2,00 bis 6,00 Pa (15 bis 45 Millitorr) umfasst;
Anlegen einer Spannung von -500 V an das Substrat (12), Erhöhen der Spannung auf -1000 V und 2 Minuten Halten dieser Spannung;
Unterbrechen der Sauerstoffzufuhr, Einleiten von Argon und dann Evakuieren der Vakuumkammer auf 6,66 mPa (50 Mikrotorr);
ii) ein Magnetron-Sputterverfahren, das das Einleiten von Argon in die Vakuumkammer bis zu einem Druck von 0,267 bis 2,67 Pa (2 bis 20 Millitorr) umfasst;
Anlegen einer Leistungsdichte von etwa 14 W/cm² bis 28 W/cm² an das Target während einer Zeit von 1 bis 3 Minuten;
Anlegen wenigstens einer hohen Vorspannung von -200 bis -700 V an das Substrat (12) während einer Minute; und
Anlegen einer niedrigen Vorspannung von -20 bis -60 V an das Substrat (12) während 2 bis 5 Minuten, wodurch eine minimale Dicke eines titanhaltigen Materials von 5 nm auf der Schneidkante abgeschieden wird;
iii) einen α-Diamant-Schritt oder diamantähnlicher-Kohlenstoff(DLC)-Schritt;
Einleiten von Argon in die Vakuumkammer bis zu einem Druck von 2,66 mPa bis 1,20 Pa (20 Mikrotorr bis 9 Millitorr);
Einstellen der Kathodenlichtbogenquellen auf etwa 50 bis 65 Ampere mit einer Anfangsvorspannung von etwa -500 bis -1000 V, die an das Substrat (12) angelegt wird, wobei die partielle Titancarbidschicht (14) entsteht;
iv) Fortsetzen von Schritt iii) unter Abscheiden einer 20 bis 150 nm (200 bis 1500 Ängström) dicken Hartkohlenstoffschicht (16);
wobei das Sputterverfahren in einer ersten Atmosphäre durchgeführt wird, die Argon mit einem Druck von 6,65 Pa (50 Millitorr) umfasst, wobei in die Schicht aus titanhaltigem Material (14) Kohlenstoff implantiert wird, so dass eine partielle Titancarbidschicht entsteht, wobei das Implantieren mit einer zweiten Vorspannung durchgeführt wird, die positiver als -1500 Volt ist und an die Rasierklinge angelegt wird.

2. Verfahren gemäß Anspruch 1, wobei in Schritt iii) zwei Kathodenlichtbogenquellen so angeordnet sind, dass jeder Kohlenstoffstrahl senkrecht auf einer der Fasen (22) der Schneidkante steht.

3. Verfahren gemäß Anspruch 2, wobei die beiden Kathodenlichtbogenquellen unter einem Winkel von 60 Grad zwischen den beiden Kohlenstoffstrahlen angeordnet sind.

4. Verfahren gemäß Anspruch 1, wobei das Hartkohlenstoffmaterial aus der Gruppe ausgewählt ist, die aus diamantähnlichem Kohlenstoff und amorphem Diamant besteht.

5. Verfahren gemäß Anspruch 1, wobei das Polytetrafluorethylen ein Molekulargewicht von 40 000 aufweist.

6. Verfahren gemäß Anspruch 1, wobei sich die Schicht aus Polytetrafluorethylen (18) auf der Schicht aus Hartkohlenstoffmaterial (16) befindet.

7. Verfahren gemäß Anspruch 4, wobei die Schicht aus Hartkohlenstoffmaterial (16) eine Dicke zwischen 20 und 80 nm aufweist.

## Revendications

1. Procédé de fabrication d'une lame de rasoir (10), comprenant :
un substrat (12) avec un bord tranchant défini par une pointe affûtée (20) et des facettes adjacentes (22),
une couche de matériau contenant du titane (14) sur le bord tranchant,
une couche de matériau de carbone dur (16) sur la couche de matériau contenant du titane (14), et
une couche externe de polytétrafluoroéthylène (18)
dans lequel la couche de matériau contenant du titane (14) est une couche de carbure de titane partielle, ledit procédé comprenant :
l'octroi au substrat (12) du bord tranchant défini par la pointe affûtée (20) et les facettes adjacentes (22), l'ajout de la couche de matériau contenant du titane (14) au bord tranchant, l'ajout de matériau de carbone dur (16) à la couche de matériau contenant du titane (14) et l'ajout de la couche externe de polytétrafluoroéthylène (18), la couche de matériau contenant du titane (14) comprenant le dépôt de la couche de matériau contenant du titane (14) au moyen d'un procédé de dépôt physique en phase vapeur,
dans lequel le procédé de dépôt physique en phase vapeur est un procédé de pulvérisation cathodique,
dans lequel le procédé de pulvérisation cathodique est réalisé dans une chambre à vide qui contient une cible qui comprend du titane,
dans lequel les étapes de procédé réalisées dans ladite chambre à vide comprennent les étapes suivantes :
i) une étape de décharge luminescente comprenant l'introduction d'oxygène dans la chambre à vide à une pression de 2,00 à 6,00 Pa (15 à 45 milliTorrs),
l'application d'une tension de - 500 V au substrat (12), l'augmentation de la tension à - 1000 V et le maintien de celle-ci pendant 2 minutes,
la fermeture de la réserve d'oxygène, l'introduction d'argon et ensuite, l'évacuation de la chambre à vide à 6,66 mPa (50 microTorrs) ;
ii) un procédé de pulvérisation magnétron comprenant l'introduction d'argon dans la chambre à vide à une pression de 0,267 à 2,67 Pa (2 à 20 milliTorrs),
l'application d'une densité de puissance d'environ 14 W/cm² à 28 W/cm² sur la cible pendant une durée de 1 à 3 minutes,
l'application d'au moins une tension de polarisation élevée de - 200 à - 700 V sur le substrat (12) pendant une minute, et
l'application d'une tension de polarisation basse de - 20 à - 60 V sur le substrat (12) pendant 2 à 5 minutes pour déposer ainsi une épaisseur minimale de matériau contenant du titane de 5 nm sur le bord tranchant ;
iii) une étape de diamant α ou de carbone sous forme de diamant amorphe (CDA)
l'introduction d'argon dans la chambre à vide à une pression de 2,66 mPa à 1,20 Pa (20 microTorrs à 9 milliTorrs),
le réglage des sources d'arc cathodique à environ 50 à 65 amps avec une tension de polarisation initiale d'environ - 500 à - 1000 V appliquée au substrat (12) pour former la couche de carbure de titane partielle (14) ;
iv) la poursuite de l'étape iii) avec dépôt d'une couche de carbone dur (16) de 20 à 150 nm (200 à 1500 Angströms) d'épaisseur ;
dans lequel le procédé de pulvérisation cathodique est réalisé dans une première atmosphère comprenant de l'argon ayant une pression inférieure à 6,65 Pa (50 milliTorrs), la couche de matériau contenant du titane (14) étant implantée avec du carbone pour former une couche de carbure de titane partielle, l'implantation étant réalisée avec une seconde tension de polarisation plus positive que - 1500 volts appliquée à la lame de rasoir.

2. Procédé selon la revendication 1, dans lequel dans l'étape iii) deux sources d'arc cathodique sont situées de telle sorte que chaque faisceau carbone est normal à l'une de chaque facette (22) du bord tranchant.

3. Procédé selon la revendication 2, dans lequel les deux sources d'arc cathodique sont situées à un angle de 60 degrés entre les deux faisceaux carbone.

4. Procédé selon la revendication 1, dans lequel le matériau de carbone dur est choisi dans le groupe constitué de carbone sous forme de diamant et de diamant amorphe.

5. Procédé selon la revendication 1, dans lequel le polytétrafluoroéthylène a un poids moléculaire de 40 000.

6. Procédé selon la revendication 1, dans lequel la couche de polytétrafluoroéthylène (18) est sur la couche de matériau de carbone dur (16).

7. Procédé selon la revendication 4, dans lequel la couche de matériau de carbone dur (16) a une épaisseur comprise entre 20 et 80 nm.
